(19) Europäisches Patentamt / European Patent Office / Office européen des brevets

(11) **EP 2 578 652 A1**

(12) **EUROPEAN PATENT APPLICATION**
published in accordance with Art. 153(4) EPC

(43) Date of publication:
**10.04.2013 Bulletin 2013/15**

(51) Int Cl.:
**C09J 7/02** (2006.01)   **C09J 11/04** (2006.01)
**C09J 133/00** (2006.01)   **H01L 21/36** (2006.01)

(21) Application number: **11789708.2**

(22) Date of filing: **27.05.2011**

(86) International application number:
**PCT/JP2011/062201**

(87) International publication number:
**WO 2011/152305 (08.12.2011 Gazette 2011/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.06.2010 JP 2010127890**

(71) Applicant: **Nitto Denko Corporation
Osaka 567-8680 (JP)**

(72) Inventors:
• **SHOUJI, Akira
  Ibaraki-shi
  Osaka 567-8680 (JP)**

• **TSUKAGOSHI, Tatsuya
  Ibaraki-shi
  Osaka 567-8680 (JP)**
• **FURUTA, Kenji
  Ibaraki-shi
  Osaka 567-8680 (JP)**
• **TOJO, Midori
  Ibaraki-shi
  Osaka 567-8680 (JP)**
• **TERADA, Yoshio
  Ibaraki-shi
  Osaka 567-8680 (JP)**

(74) Representative: **Stolmár & Partner
Blumenstraße 17
80331 München (DE)**

(54) **SHEET PRODUCT**

(57)    A sheet product including a sheet-shaped pressure-sensitive adhesive sheet having pressure-sensitive adhesiveness; a base separator disposed on one surface side of the pressure-sensitive adhesive sheet so as to be peelable from the pressure-sensitive adhesive sheet, and supporting the pressure-sensitive adhesive sheet and serving as a base; and a protective separator disposed on the other surface side of the pressure-sensitive adhesive sheet so as to be peelable from the pressure-sensitive adhesive sheet, wherein the peel force between the pressure-sensitive adhesive sheet and the base separator is smaller than the peel force between the pressure-sensitive adhesive sheet and the protective separator and is 0.05 to 0.8 N/50 mm; a cut is given to the pressure-sensitive adhesive sheet and the protective separator in the direction of the thickness of the pressure-sensitive adhesive sheet such that the pressure-sensitive adhesive sheet and the protective separator can be peeled from the base separator as a separate piece in the state where the pressure-sensitive adhesive sheet and the protective separator are layered; the thickness of the base separator is not less than 60 $\mu$m; and in the base separator and the protective separator, the respective surface roughness Ra on the side of the pressure-sensitive adhesive sheet is not more than 3 $\mu$m.

Fig. 1(a)

# Fig. 1(b)

5

A          A

3

1

2

**Description**

TECHNICAL FIELD

The present invention relates to sheet products, and specifically relates to a sheet product including a sheet-shaped pressure-sensitive adhesive sheet having pressure-sensitive adhesiveness and thermal conductivity, in which the pressure-sensitive adhesive sheet is used by being disposed between a heat generating source, such as an electronic device, and a heat sink for dissipating heat.

BACKGROUND ART

As the conventional sheet product of this kind, sheet products including the pressure-sensitive adhesive sheet and a base separator are known, the base separator being disposed on one surface side of the pressure-sensitive adhesive sheet so as to be peelable from the pressure-sensitive adhesive sheet, supporting the pressure-sensitive adhesive sheet before usage, and serving as a base for the pressure-sensitive adhesive sheet. In use of the sheet product of this kind, for example, the base separator is peeled from the pressure-sensitive adhesive sheet when the pressure-sensitive adhesive sheet is used, and the pressure-sensitive adhesive sheet is used by being disposed between the heat generating source and the heat sink to transfer the heat from the heat generating source via the pressure-sensitive adhesive sheet to the heat sink.

As the sheet product of this kind, specifically, a sheet product has been proposed in which a cut is given to the pressure-sensitive adhesive sheet in the direction of the thickness thereof such that the pressure-sensitive adhesive sheet can be peeled from the base separator as a sheet-shaped separate piece, for example (Patent Document 1).

Moreover, as the sheet product of this kind, a sheet product further including a protective separator has been proposed in which the protective separator is disposed on the side opposite to the base separator and can be peeled from the pressure-sensitive adhesive sheet (Patent Document 2). The sheet product including the protective separator for protecting the pressure-sensitive adhesive sheet before usage can be used by, when used, first removing only the protective separator and then peeling the separate pieces obtained by dividing the pressure-sensitive adhesive sheet from the base separator.

These sheet products are handled well because the separate pieces of the pressure-sensitive adhesive sheet (pressure-sensitive adhesive sheet pieces) can be easily peeled from the base separator by holding the piece by pinching with fingers.

Unfortunately, in these sheet products, when the pressure-sensitive adhesive sheet piece is directly pinched with the fingers, the surface of the pressure-sensitive adhesive sheet piece may be contaminated, and as a result, predetermined physical properties may not be provided in the pressure-sensitive adhesive sheet piece having physical properties such as pressure-sensitive adhesiveness and thermal conductivity.

Contrary to this, Patent Document 2 also proposes a sheet product including the pressure-sensitive adhesive sheet, the sheet-shaped base separator, and the sheet-shaped protective separator as described above, and cut in the direction of the thickness thereof into small piece sheets such that the shape of the small piece sheet matches the shape of an applied portion of an adherend.

In the sheet product, first, a base separator piece can be peeled from the pressure-sensitive adhesive sheet piece. Next, the pressure-sensitive adhesive sheet piece laminated on a protective separator piece can be attached to the adherend, and the protective separator piece can be peeled from the pressure-sensitive adhesive sheet piece with the pressure-sensitive adhesive sheet piece being attached to the adherend. Accordingly, the possibility of contamination of the pressure-sensitive adhesive sheet piece by the fingers or the like is reduced.

Unfortunately, when the sheet product is cut, air bubbles may enter between the pressure-sensitive adhesive sheet piece and the base separator piece or between the pressure-sensitive adhesive sheet piece and the protective separator piece. Surface physical properties of the pressure-sensitive adhesive sheet piece may be affected by the air bubbles and changed, leading to defectives and reduced yield.

Moreover, in the sheet product, the air bubbles produced in cutting may greatly vary the peel force between the pressure-sensitive adhesive sheet piece and the base separator piece and that between the pressure-sensitive adhesive sheet piece and the protective separator piece. This may cause the so-called "naki-wakare" or unintended peeling in use of the sheet product in which the pressure-sensitive adhesive sheet piece is unintendedly peeled from both of the base separator piece and the protective separator piece. When the "naki-wakare" occurs, the sheet product may be difficult to handle, reducing workability.

As described above, the conventional sheet products have a problem such that the yield and the workability in use are not always high.

CITATION LIST

PATENT DOCUMENT

Patent Document 1: Japanese Patent Laid-Open No. 2007-059464
Patent Document 2: Japanese Patent Laid-Open No. 2002-084083

SUMMARY OF INVENTION

TECHNICAL PROBLEM

The present invention has been made in consideration of the problems above, and an object of the present invention is to provide a sheet product having a high yield and high workability in use.

SOLUTION TO PROBLEM

The sheet product according to the present invention is a sheet product including a sheet-shaped pressure-sensitive adhesive sheet having pressure-sensitive adhesiveness; a base separator disposed on one surface side of the pressure-sensitive adhesive sheet so as to be peelable from the pressure-sensitive adhesive sheet, and supporting the pressure-sensitive adhesive sheet and serving as a base; and a protective separator disposed on the other surface side of the pressure-sensitive adhesive sheet so as to be peelable from the pressure-sensitive adhesive sheet, wherein the peel force between the pressure-sensitive adhesive sheet and the base separator is smaller than the peel force between the pressure-sensitive adhesive sheet and the protective separator and is 0.05 to 0.8 N/50 mm; a cut is given to the pressure-sensitive adhesive sheet and the protective separator in the direction of the thickness of the pressure-sensitive adhesive sheet such that the pressure-sensitive adhesive sheet and the protective separator can be peeled from the base separator as a separate piece in the state where the pressure-sensitive adhesive sheet and the protective separator are layered; the thickness of the base separator is not less than 60 $\mu$m; and in the base separator and the protective separator, the respective surface roughness Ra on the side of the pressure-sensitive adhesive sheet is not more than 3 $\mu$m.
In the sheet product, the peel force between the pressure-sensitive adhesive sheet and the base separator is not less than 0.05 N/50 mm. The peel force between the pressure-sensitive adhesive sheet and the protective separator is larger than the peel force between the pressure-sensitive adhesive sheet and the base separator. The peel force between the pressure-sensitive adhesive sheet and the base separator and the peel force between the pressure-sensitive adhesive sheet and the protective separator are relatively large. Accordingly, the cut given to the pressure-sensitive adhesive sheet also suppresses entry of air bubbles between the pressure-sensitive adhesive sheet and these separators, suppressing change in the surface physical properties of the pressure-sensitive adhesive sheet caused by the air bubbles and production of defectives.
The base separator and the protective separator each have a surface roughness Ra on the side of the pressure-sensitive adhesive sheet of not more than 3 $\mu$m. Accordingly, the cut given to the pressure-sensitive adhesive sheet also suppresses entering of the air bubbles between the pressure-sensitive adhesive sheet and these separators. Accordingly, change in the surface physical properties of the pressure-sensitive adhesive sheet caused by the air bubbles and production of defectives are suppressed.
Additionally, variation in the peel force between the pressure-sensitive adhesive sheet and the base separator and that between the pressure-sensitive adhesive sheet and the protective separator, which may be caused by the air bubbles, is suppressed. Accordingly, the occurrence of unintended peeling, i.e., the so-called "naki-wakare" is suppressed, suppressing reduction in workability.
The peel force between the pressure-sensitive adhesive sheet and the base separator is not more than 0.8 N/50 mm and is smaller than the peel force between the pressure-sensitive adhesive sheet and the protective separator. For this reason, the pressure-sensitive adhesive sheet and the protective separator can be easily peeled along the cut from the base separator in the state where the pressure-sensitive adhesive sheet and the protective separator remain layered. Accordingly, workability in use is high.
The thickness of the base separator is not less than 60 $\mu$m. For this reason, the cut given to the pressure-sensitive adhesive sheet and the protective separator is prevented from penetrating the base separator, and the possibility of defectives is also reduced.
Thus, the sheet product according to the present invention has a high yield and high workability in use.
Preferably, in the sheet product according to the present invention, the pressure-sensitive adhesive sheet contains an acrylic polymer and a thermally conductive filler. When the pressure-sensitive adhesive sheet contains the thermally conductive filler, it is advantageous in that the pressure-sensitive adhesive sheet also has thermal conductivity. When the pressure-sensitive adhesive sheet contains the acrylic polymer, it is advantageous in that the pressure-sensitive adhesive sheet may more easily be pressure-sensitively adhered to an adherend, and may have higher workability.

In the sheet product according to the present invention, the cut is preferably given in a lattice form such that the separate piece of the pressure-sensitive adhesive sheet and the protective separator layered can be peeled from the base separator as a small sheet-shaped rectangular piece.

Preferably, the peel force between the pressure-sensitive adhesive sheet and the protective separator is more than 0.05 N/50 mm.

In the sheet product according to the present invention, the thickness of the protective separator is preferably less than the thickness of the base separator, and the thickness of the protective separator is preferably not less than 20 $\mu$m.

In the sheet product according to the present invention, the base separator and the protective separator are preferably formed from a backing of the same kind.

ADVANTAGEOUS EFFECTS OF INVENTION

As above, the sheet product according to the present invention attains effects of a high yield and high workability in use.

BRIEF DESCRIPTION OF DRAWINGS

Fig. 1(a) is a schematic plan view of a sheet product and Fig. 1(b) is a schematic front view of the sheet product.
Figs. 2(a) and 2(b) are drawings schematically showing the manner when the sheet product is used.
Fig. 3 is a drawing schematically showing a modification of the sheet product.

DESCRIPTION OF EMBODIMENT

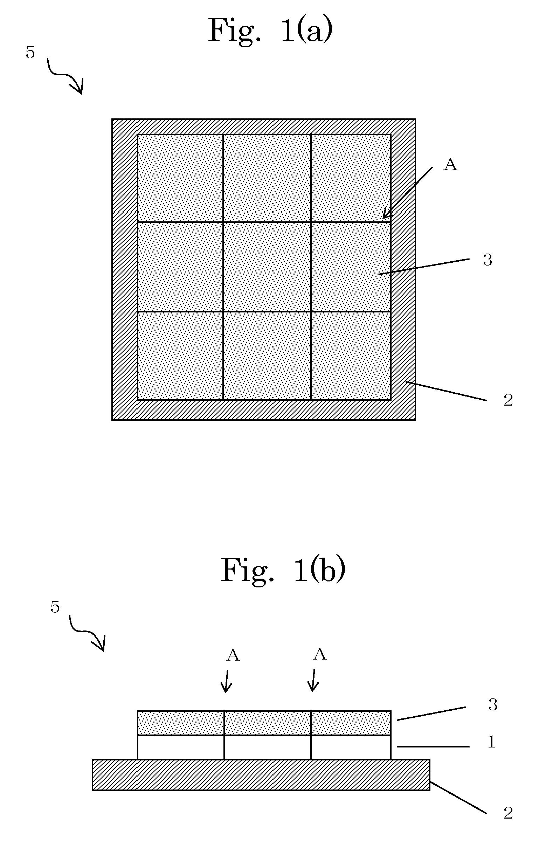

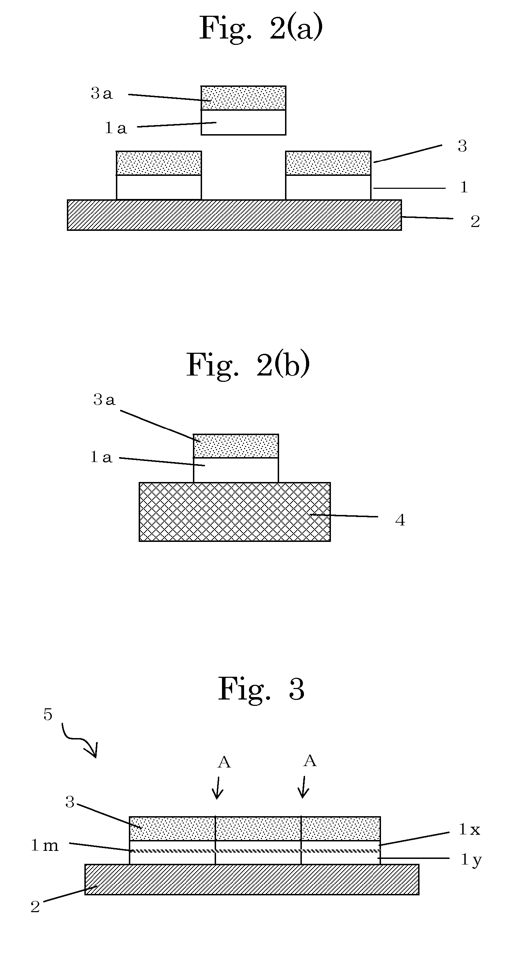

Hereinafter, an embodiment of a sheet product according to the present invention will be described with reference to the drawings. Figs. 1(a) and 1(b) are drawings schematically showing the sheet product. Specifically, Fig. 1(a) is a plan view schematically showing the sheet product when the base separator faces downwardly. Fig. 1(b) is a front view schematically showing the sheet product. Figs. 2(a) and 2(b) are drawings schematically showing an example of the manner when the sheet product is used.

As shown in Fig. 1, a sheet product 5 according to the present embodiment is a sheet product 5 including a pressure-sensitive adhesive sheet 1 having pressure-sensitive adhesiveness, a base separator 2 disposed on one surface side of the pressure-sensitive adhesive sheet 1 to be peelable from the pressure-sensitive adhesive sheet, and a sheet-shaped protective separator 3 disposed on the other surface side of the pressure-sensitive adhesive sheet 1 to be peelable from the pressure-sensitive adhesive sheet, wherein the peel force between the pressure-sensitive adhesive sheet 1 and the base separator 2 is smaller than the peel force between the pressure-sensitive adhesive sheet 1 and the protective separator 3 and is 0.05 to 0.8 N/50 mm; a cut is given to the pressure-sensitive adhesive sheet 1 and the protective separator 3 in the direction of the thickness of the pressure-sensitive adhesive sheet 1 such that the pressure-sensitive adhesive sheet 1 and the protective separator 3 can be peeled from the base separator 2 as a separate piece in the state where the pressure-sensitive adhesive sheet 1 and the protective separator 3 are layered; and the thickness of the base separator 2 is not less than 60 $\mu$m. In the base separator and the protective separator, the respective surface roughness Ra on the side of the pressure-sensitive adhesive sheet is not more than 3 $\mu$m.

As shown in Fig. 1, the sheet product 5 includes the pressure-sensitive adhesive sheet 1 disposed between the base separator 2 and the protective separator 3, the base separator 2 supporting the pressure-sensitive adhesive sheet and serving as a base. A cut A is given to the pressure-sensitive adhesive sheet 1 and the protective separator 3 in the direction of the thickness thereof so as to penetrate the pressure-sensitive adhesive sheet 1 and the protective separator 3. Thereby, the pressure-sensitive adhesive sheet 1 and the protective separator 3 layered are formed as a sheet-shaped separate piece peelable from the base separator 2.

The cut A is preferably given such that the shape of the separate piece obtained by dividing the pressure-sensitive adhesive sheet 1 and the protective separator 3 matches the shape of an applied portion of an adherend. Specifically, for example, as shown in Fig. 1(a) and Fig. 1(b), the cut A is preferably given in a lattice form to the pressure-sensitive adhesive sheet 1 and the protective separator 3 such that the separate piece thereof can be peeled from the base separator 2 as a small sheet-shaped rectangular piece.

In the sheet product 5, first, usually, the pressure-sensitive adhesive sheet 1 in the separate piece (pressure-sensitive adhesive sheet piece 1a) and the protective separator 3 in the separate piece (protective separator piece 3a) are peeled from the base separator 2 as a separate piece in the state where the pressure-sensitive adhesive sheet 1 and the protective separator 3 are layered, as shown in Fig. 2(a). Next, as shown in Fig. 2(b), the separate piece on the side of the pressure-sensitive adhesive sheet piece 1a is applied to a heat generating body 4 in an electronic device or the like. Then, the protective separator piece 3a is removed from the separate piece, and a heat sink (not shown) or the like is attached to the exposed pressure-sensitive adhesive sheet piece 1a. Thereby, the heat generating body 4, such as an electronic device, is fixed to the heat sink or the like.

The peel force between the base separator 2 and the pressure-sensitive adhesive sheet 1 is measured by a 180° peeling peel force described in Examples. The peel force between the protective separator 3 and the pressure-sensitive adhesive sheet 1 is also measured by the same method.

The peel force between the base separator 2 and the pressure-sensitive adhesive sheet 1 is 0.05 to 0.8 N/50 mm, preferably 0.08 to 0.5 N/50 mm, and more preferably 0.2 to 0.3 N/50 mm. If the peel force between the base separator 2 and the pressure-sensitive adhesive sheet 1 is less than 0.05 N/50 mm, the peel force is insufficient. If the cut A is given to the protective separator 3 and the pressure-sensitive adhesive sheet 1 by punching or the like, air bubbles may enter between the pressure-sensitive adhesive sheet 1 and the separator. If the peel force between the base separator 2 and the pressure-sensitive adhesive sheet 1 is more than 0.8 N/50 mm, the pressure-sensitive adhesive sheet 1 may be difficult to remove from the base separator 2, reducing the workability.

The peel force between the base separator 2 and the pressure-sensitive adhesive sheet 1 is smaller than the peel force between the protective separator 3 and the pressure-sensitive adhesive sheet 1. Thereby, the pressure-sensitive adhesive sheet piece 1a and the protective separator piece 3a can be peeled from the base separator 2 in the state where the pressure-sensitive adhesive sheet piece 1a and the protective separator piece 3a are layered.

Preferably, the peel force between the base separator 2 and the pressure-sensitive adhesive sheet 1 is 0.01 N/50 mm or more smaller than the peel force between the protective separator 3 and the pressure-sensitive adhesive sheet 1. Namely, the difference between the peel force between the base separator 2 and the pressure-sensitive adhesive sheet 1 and the peel force between the protective separator 3 and the pressure-sensitive adhesive sheet 1 is preferably not less than 0.01 N/50 mm. When the difference between the peel forces is not less than 0.01 N/50 mm, the occurrence of the "naki-wakare" is further suppressed, providing higher workability in use. The difference between the peel forces is more preferably not less than 0.02 N/50 mm. Because higher workability in use is provided, the difference between the peel forces is preferably not more than 0.05 N/50 mm.

The peel force between the protective separator 3 and the pressure-sensitive adhesive sheet 1 is more than 0.05 N/50 mm. When the peel force is relatively large as above, entering of the air bubbles between the protective separator 3 and the pressure-sensitive adhesive sheet 1 when the cut A is given is suppressed. Accordingly, variation in the peel force caused by the air bubbles is suppressed, suppressing the occurrence of the "naki-wakare" when the sheet product 5 is used.

The peel force between the protective separator 3 and the pressure-sensitive adhesive sheet 1 is preferably 0.10 to 1.0 N/50 mm, more preferably 0.25 to 0.5 N/50 mm, and still more preferably 0.25 to 0.35 N/50 mm. When the peel force between the protective separator 3 and the pressure-sensitive adhesive sheet 1 is not less than 0.10 N/50 mm, it is advantageous in that a force needed for peeling is increased, and mixing of the air bubbles accompanied by giving the cut A is further suppressed. When the peel force is not more than 1.0 N/50 mm, it is advantageous in that the protective separator 3 is more easily peeled from the pressure-sensitive adhesive sheet 1, providing higher workability when the sheet product 5 is used.

The peel force between the base separator 2 and the pressure-sensitive adhesive sheet 1 or the peel force between the protective separator 3 and the pressure-sensitive adhesive sheet 1 can be properly adjusted by changing the material for the pressure-sensitive adhesive sheet 1, for example. More specifically, for example, the peel force can be adjusted by using a material having different pressure-sensitive adhesiveness for the pressure-sensitive adhesive sheet 1.

The thickness of the base separator 2 is a length in the same direction as the direction of the thickness of the pressure-sensitive adhesive sheet 1. The thickness is not less than 60 $\mu$m, and preferably not less than 90 $\mu$m. At a thickness less than 60$\mu$m, the cut A given by a punching blade or the like during production may penetrate the base separator 2, providing defectives of the sheet product 5. The thickness is preferably not more than 150 $\mu$m, and more preferably not more than 135 $\mu$m. At a thickness not more than 150 $\mu$m, it is advantageous in that the sheet product 5 can be formed into a relatively thin sheet-shaped product, and can be easily handled when the sheet product is wound up, or the like. The base separator 2 is usually of a sheet shape.

The thickness of the protective separator 3 is preferably less than the thickness of the base separator 2 because the pressure-sensitive adhesive sheet piece 1a and the protective separator piece 3a layered can be more easily peeled from the base separator 2.

The thickness of the protective separator 3 is preferably not less than 20 $\mu$m, and more preferably not less than 40 $\mu$m.

At a thickness of the protective separator 3 of not less than 20 $\mu$m, it is advantageous in that the protective separator piece 3a can be more easily peeled from the pressure-sensitive adhesive sheet piece 1a, and higher workability can be provided. The thickness is preferably not more than 150 $\mu$m, and more preferably not more than 135 $\mu$m. At a thickness of not more than 150 $\mu$m, it is advantageous in that the thickness of the sheet product 5 is thinner, and the sheet product 5 can be more easily handled when the sheet product is wound up, or the like.

In the base separator and the protective separator, the respective surface roughness Ra on the side of the pressure-sensitive adhesive sheet is not more than 3 $\mu$m. The respective surface roughness Ra is preferably 0.01 to 1 $\mu$m, and more preferably 0.03 to 0.3 $\mu$m. At a respective surface roughness Ra of not more than 1 $\mu$m in the base separator and the protective separator, it is advantageous in that entering of the air bubbles between the separator and the pressure-sensitive adhesive sheet 1 is suppressed in a process to give the cut A (hereinafter, also referred to as a half cut process), increase in the thermal resistance of the pressure-sensitive adhesive sheet 1 by an influence of the air bubbles is further suppressed.

The value of the surface roughness Ra can be adjusted by adjusting a degree of a standard process such as embossing.

The surface roughness Ra means arithmetic average roughness (Ra) defined by JIS B0601 (2001). The arithmetic average roughness is measured using a non-contact three-dimensional stylus surface profiler "NT8000" made by Veeco Instruments Inc.

The thickness of the pressure-sensitive adhesive sheet 1 is not particularly limited. The thickness is usually 20 to 200 $\mu$m, and more preferably 30 to 130 $\mu$m.

Examples of the backing that forms the base separator 2 or the protective separator 3 (hereinafter, also referred to as a backing for a separator) include a variety of backings made of plastics, papers, and metals. The backing may be made of fibers.

The form of the backing for a separator may be a single layer body or a laminate.

Examples of the plastic backings include a variety of plastic backings such as backings made of polyolefins (such as polyethylenes, polypropylenes, polybutenes, polybutadienes, ethylene-propylene copolymers, and ethylene-1-butene copolymers); polyesters (such as polyethylene terephthalate, polyethylene naphthalate, and polybutylene terephthalate); polyacrylates; polyurethanes; "nylon 6" obtained by ring-opening polymerization of $\varepsilon$-caprolactam; "nylon 6,6 (trade name)" obtained by polymerizing adipic acid with hexamethylenediamine, or polyamides using partial aromatic polyamides; polyvinyl chloride; polyvinylidene chloride; polycarbonates; ethylene-vinyl acetate copolymers; ethylene-ethylacrylate copolymers; ethylene-vinylalcohol copolymers; and celluloses. Among these, preferred are polyester backings such as polyethylene terephthalate backings because these have high workability when the sheet product is produced or used.

Examples of the paper backings include those selected from a variety of paper backings such as backings made of Japanese paper, high quality paper, glassine paper, kraft paper, Clupak paper, crepe paper, clay coated paper, top coated paper, and synthetic paper.

In the case where a separator having a plastic laminate layer formed on the paper backing is used, the separator can be produced by the method described in Japanese Patent Laid-Open No. 2005-15933, for example.

Materials for the plastic laminate layers are not particularly limited, and a variety of plastic materials (thermoplastic resins) are used. Examples of the materials specifically include a variety of polyolefin resins such as polyethylene, polypropylene, and 4-methyl-1-pentene; vinylidene chloride copolymers; and copolymers of ethylene and acrylic acid, methacrylic acid, acrylic acid ester, methacrylic acid ester, or vinyl acetate.

As the material for the plastic laminate layer, preferred are polyethylene resins because of easiness of handling in the half cut process. Examples of the polyethylene resins include low density polyethylene resins, middle density polyethylene resins, high density polyethylene resins, and linear low density polyethylene resins.

In the base separator 2 and the protective separator 3, when a polyester backing is used for one of these separators, a polyester backing is also preferably used for the other thereof. When a paper backing is used for one of these separators, a paper backing is also preferably used for the other thereof. Namely, preferably, the base separator 2 and the protective separator 3 are formed from a backing of the same kind. When the base separator 2 and the protective separator 3 are formed from a backing of the same kind, it is advantageous in that processability in the half cut process is enhanced.

When necessary, the base separator 2 and the protective separator 3 may be subjected to a releasing treatment or dirt resistant treatment using a silicone-containing mold release agent, a fluorine-containing mold release agent, a long-chain alkyl mold release agent, a fatty acid amide mold release agent, or silica powder.

Particularly, when the surface of the separator is subjected to the releasing treatment using a silicone-containing mold release agent, a long-chain alkyl mold release agent, or a fluorine-containing mold release agent, peelability from the pressure-sensitive adhesive sheet 1 can be further enhanced.

Namely, by performing the releasing treatment on the separator, the peel force between the pressure-sensitive adhesive sheet 1 and the base separator 2 or the peel force between the pressure-sensitive adhesive sheet 1 and the protective separator 3 can be further reduced. When the amount of the mold release agent to be used in the releasing treatment is increased, the peel force can be further reduced. The peel force can also be properly adjusted by, for example, changing the kind of the mold release agent used in the releasing treatment, or changing the method of applying the mold release agent to the separator.

The backing for a separator may be subjected to a charge preventing treatment by applying, compounding, or depositing a standard antistatic agent, or the like. The surface of the backing for a separator can also be subjected to a variety of surface processes such as a corona discharge treatment process or embossing when necessary.

The initial elastic modulus of each of the separators is preferably 1 to 10 GPa, and more preferably 2 to 8 Gpa. At an initial elastic modulus of not less than 1 GPa, it is advantageous in that the separator has higher strength, and breakage of the separator and occurrence of wrinkles in production are suppressed. At an initial elastic modulus of not more than 10 GPa, it is advantageous in that strength of the separator is properly reduced, and mixing of the air bubbles in the half cut process can be suppressed.

The initial elastic modulus is measured according to the "tensile modulus of elasticity" in JIS K7161. According to JIS K7127, measurement is performed under the conditions of a test piece type 2, a width of the test sample of 10 mm, and a tensile rate of 300 mm/min.

Subsequently, the present invention will be described more in detail using an example of a thermally conductive sheet product including a pressure-sensitive adhesive sheet having pressure-sensitive adhesiveness and thermal conductivity (hereinafter, also referred to as a thermally conductive pressure-sensitive adhesive sheet) as the pressure-sensitive adhesive sheet.

The thermally conductive pressure-sensitive adhesive sheet in the thermally conductive sheet product contains an acrylic polymer and a thermally conductive filler. When the thermally conductive pressure-sensitive adhesive sheet contains the acrylic polymer, it is advantageous in that pressure-sensitive adhesiveness to the adherend can be enhanced, and the pressure-sensitive adhesive sheet can be difficult to peel from the adherend, providing higher workability. When the thermally conductive pressure-sensitive adhesive sheet contains the thermally conductive filler, it is advantageous in that the heat is conducted efficiently between the adherends attached to both surfaces of the thermally conductive pressure-sensitive adhesive sheet.

The acrylic polymer has a (meth)acrylic monomer, as a monomer unit, represented by the following Formula (1):

$$CH_2 = C(R^1)COOR^2 \quad (1)$$

(wherein $R^1$ is hydrogen or a methyl group, and $R^2$ is an alkyl group having 1 to 18 carbon atoms.)

In the Formula (1), the alkyl group in $R^2$ has preferably 3 to 12 carbon atoms, and more preferably 4 to 9 carbon atoms. The alkyl group in $R^2$ may be one of a linear alkyl group and a branched chain alkyl group. Preferred is the branched chain alkyl group because the glass transition temperature is lower.

Examples of the (meth)acrylic monomer represented by the Formula (1) specifically include methyl (meth)acrylate, ethyl (meth)acrylate, n-butyl (meth)acrylate, s-butyl (meth)acrylate, t-butyl (meth)acrylate, isobutyl (meth)acrylate, n-pentyl (meth)acrylate, isopentyl (meth)acrylate, hexyl (meth)acrylate, heptyl (meth)acrylate, isoamyl (meth)acrylate, 2-ethylhexyl (meth)acrylate, n-octyl (meth)acrylate, isooctyl (meth)acrylate, n-nonyl (meth)acrylate, isononyl (meth)acrylate, n-decyl (meth)acrylate, isodecyl (meth)acrylate, n-dodecyl (meth)acrylate, isomyristyl (meth)acrylate, n-tridecyl (meth)acrylate, n-tetradecyl (meth)acrylate, pentadecyl (meth)acrylate, hexadecyl (meth)acrylate, stearyl (meth)acrylate, and isostearyl (meth)acrylate.

One of the (meth)acrylic monomers represented by the Formula (1) can be used alone, or two or more thereof can be used in combination.

The content of the (meth)acrylic monomer represented by the Formula (1) in the acrylic polymer is preferably 50 to 98% by weight, more preferably 60 to 98% by weight, and still more preferably 70 to 98% by weight. When 50% by weight or more of the (meth)acrylic monomer is contained in the acrylic polymer, it is advantageous in that the pressure-sensitive adhesiveness of the pressure-sensitive adhesive sheet can be enhanced.

As the acrylic polymer, preferred are those obtained by polymerization using a polar group-containing monomer such as a hydroxy group-containing monomer and a carboxyl group-containing monomer.

As the acrylic polymer, preferred are those obtained by polymerization using preferably 0.1 to 20% by weight of the polar group-containing monomer, more preferably 0.2 to 10% by weight, and still more preferably 0.2 to 7% by weight based on the total monomers. When 0.1% by weight or more of the polar group-containing monomer based on the total monomers is used for polymerization, it is advantageous in that the pressure-sensitive adhesive sheet has a more sufficient aggregation force. When 20% by weight or less of the polar group-containing monomer based on the total monomers is used for polymerization, it is advantageous in that the pressure-sensitive adhesiveness of the acrylic polymer to be obtained can be enhanced.

The hydroxy group containing monomer is a polymerizable monomer having one or more hydroxy groups in the molecule.

Examples of the hydroxy group containing monomer include 2-hydroxyethyl (meth)acrylate, 2-hydroxypropyl (meth)acrylate, 2-hydroxybutyl (meth)acrylate, 4-hydroxybutyl (meth)acrylate, 5-hydroxypentyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, (4-hydroxymethylcyclohexyl) methylacrylate, N-methylol (meth)acrylamide, N-hydroxy (meth)acrylamide, vinyl alcohol, allyl alcohol, 2-hydroxyethyl vinyl ether, 4-hydroxybutyl vinyl ether, and diethylene glycol monovinyl ether.

The carboxyl group containing monomer is a polymerizable monomer having one or more carboxyl groups in the molecule.
Examples of the carboxyl group containing monomer include acrylic acid, methacrylic acid, carboxyethyl (meth)acrylate, carboxypentyl (meth)acrylate, itaconic acid, maleic acid, fumaric acid, and crotonic acid. Among these, preferred are acrylic acid and methacrylic acid.

In synthesis of the acrylic polymer, in order to adjust the glass transition temperature of the acrylic polymer and the peelability of the pressure-sensitive adhesive sheet, other polymerizable monomer than the (meth)acrylic monomer, the hydroxy group-containing monomer, and the carboxyl group-containing monomer can be used in the range in which the effects of the present invention are not impaired.

Examples of the other polymerizable monomer include those that can improve aggregation force or thermal resistance of the acrylic polymer such as sulfonate group-containing monomers, phosphate group-containing monomers, nitrile group-containing monomers, vinyl ester monomers, and aromatic vinyl monomers; or those that can act as a crosslinking site in the acrylic polymer and improve the pressure-sensitive adhesive force of the acrylic polymer such as amide group-containing monomers, amino group-containing monomers, imide group-containing monomers, epoxy group-containing monomers, or vinyl ether monomers.
One of the other polymerizable monomers can be used alone, or two or more thereof can be used in combination.

Examples of the sulfonate group-containing monomer include styrene sulfonic acid, allylsulfonic acid, 2-(meth) acrylamide-2-methylpropanesulfonic acid, (meth)acrylamidepropanesulfonic acid, sulfopropyl (meth)acrylate, and (meth)acryloyloxynaphthalenesulfonic acid.

Examples of the phosphate group-containing monomer include 2-hydroxyethylacryloyl phosphate.

Examples of the nitrile group-containing monomer include acrylonitrile and methacrylonitrile.

Examples of the vinyl ester monomer include vinyl acetate, vinyl propionate, vinyl laurate, and vinylpyrrolidone.

Examples of the aromatic vinyl monomer include styrene, chlorostyrene, chloromethylstyrene, vinyltoluene, and $\alpha$-methylstyrene.

Examples of the amide group-containing monomer include (meth)acrylamide, N,N-dimethyl(meth)acrylamide, N,N-diethyl(meth)acrylamide, N,N-diethylmethacrylamide, N-isopropyl(meth)acrylamide, N-methylol(meth)acrylamide, N-methoxymethyl(meth)acrylamide, N-butoxymethyl(meth)acrylamide, dimethylaminoethyl(meth)acrylate, t-butylaminoethyl(meth)acrylate, diacetone(meth)acrylamide, N-vinylacetoamide, N,N'-methylenebis(meth)acrylamide, N,N-dimethylaminopropyl(meth)acrylamide, N-vinylcaprolactam, and N-vinyl-2-pyrrolidone.

Examples of the amino group-containing monomer include aminoethyl (meth)acrylate, N,N-dimethylaminoethyl (meth)acrylate, N,N-dimethylaminopropyl (meth)acrylate, and N-(meth)acryloylmorpholine.

Examples of the imide group-containing monomer include N-cyclohexylmaleimide, N-phenylmaleimide, N-methylmaleimide, N-ethylmaleimide, N-propylmaleimide, N-isopropylmaleimide, N-butylmaleimide, and itaconimide.

Examples of the epoxy group-containing monomer include glycidyl (meth)acrylate and allyl glycidyl ether.

Examples of the vinyl ether monomer include methyl vinyl ether, ethyl vinyl ether, and isobutyl vinyl ether.

When the other polymerizable monomer is further needed to enhance the aggregation force of the pressure-sensitive adhesive sheet or the like, (meth)acrylic acid esters of cyclic alcohols such as cyclopentyl di(meth)acrylate and isobornyl (methacrylate; (meth)acrylic acid esters of polyhydric alcohols such as neopentyl glycol di(meth)acrylate, hexanediol di(meth)acrylate, propylene glycol di(meth)acrylate, trimethylolpropane tri(meth)acrylate, tetramethylolmethane tri(meth)acrylate, and dipentaerythritol hexa(meth)acrylate; and benzene ring-containing (meth)acrylic acid esters such as phenoxyethyl (meth)acrylate, and the like can be used, for example.

One of the other polymerizable monomer can be used alone, or two or more thereof can be used in combination. The content of the other polymerizable monomer is preferably 0 to 50% by weight, more preferably 0 to 35% by weight, and still more preferably 0 to 25% by weight based on the total monomers in the acrylic polymer.

The weight average molecular weight of the acrylic polymer is preferably 600,000 or more, more preferably 700,000 to 3,000,000, and still more preferably 800,000 to 2,500,000. At a weight average molecular weight of 600,000 or more, it is advantageous in that durability of the pressure-sensitive adhesive sheet containing the acrylic polymer can be enhanced. At a weight average molecular weight of 3,000,000 or less, it is advantageous in that the pressure-sensitive adhesiveness of the pressure-sensitive adhesive sheet can be enhanced.
The weight average molecular weight refers to a value in terms of polystyrene calculated from a value obtained by measurement by GPC (gel permeation chromatography).

The glass transition temperature (Tg) of the acrylic polymer is preferably not more than -5°C, and more preferably not more than -10°C because the pressure-sensitive adhesive sheet can have a proper pressure-sensitive adhesiveness. When the glass transition temperature of the acrylic polymer is not more than -5°C, fluidity of the acrylic polymer can be increased, providing sufficient wettability to the adherend contacting the pressure-sensitive adhesive sheet (a housing, a heat sink, and a heat generating source, such as an electronic device). Accordingly, the pressure-sensitive adhesive force of the pressure-sensitive adhesive sheet can be further enhanced. The glass transition temperature (Tg) of the acrylic polymer can be controlled within the range above by properly changing the kind of the monomers to be used or the composition ratio of the monomers.

The glass transition temperature (Tg) is a value determined based on the Tgs of homopolymers of the monomers that form the acrylic polymer and the weight percentage of the monomers (copolymerizing composition) by the Fox equation represented by the following Equation (1). The Tg value of a homopolymer can be obtained from "Handbook of Pressure Sensitive Adhesive Technology" published by the Nikkan Kogyo Shimbun, Ltd., as a rule.

$$1/Tg = W_1/Tg_1 + W_2/Tg_2 + ... + W_n/Tg_n \quad (1)$$

Tg: glass transition temperature of a copolymer [K]
$Tg_n$: glass transition temperature of a homopolymer of a monomer n [K]
$W_n$: weight percentage of the monomer n

The acrylic polymer can be prepared by a variety of known radical polymerization methods. As the variety of radical polymerization methods, solution polymerization, bulk polymerization, emulsion polymerization, and the like can be properly selected. The acrylic polymer may be a homopolymer or a copolymer. In the case of a copolymer, the copolymer may be one of a random copolymer, a block copolymer, and a graft copolymer.

In the case where the acrylic polymer is prepared by the solution polymerization, ethyl acetate, toluene, and the like can be used as a polymerization solvent, for example. The polymerization solvent is usually removed by volatilization by heating or the like after the acrylic polymer is prepared.

Specific examples of solution polymerization methods for the acrylic polymer include a method in which under an inert gas stream of nitrogen or the like, using 0.01 to 0.2 parts by weight of azobisisobutyronitrile based on the 100 parts by weight of the total monomers as a polymerization initiator, a polymerization reaction is performed in a polymerization solvent at a temperature approximately 50 to 90°C for approximately 2 to 30 hours.

In the polymerization of the acrylic polymer, a polymerization initiator, a chain transfer agent, and an emulsifier can be used. These polymerization initiator, chain transfer agent, and emulsifier are not particularly limited, and known polymerization initiators, chain transfer agents, and emulsifiers can be properly selected. By use of the chain transfer agent, the molecular weight of the acrylic polymer can be properly adjusted.

As the polymerization initiator, for example, azo polymerization initiators such as 2,2'-azobisisobutyronitrile and 2,2'-azobis[N-(2-carboxyethyl)-2-methylpropionamidine]hydrate (trade name "VA-057" made by Wako Pure Chemical Industries, Ltd.); persulfate salts such as potassium persulfate and ammonium persulfate; peroxide polymerization initiators such as di(2-ethylhexyl)peroxydicarbonate, t-butyl hydroperoxide, and hydrogen peroxide; redox polymerization initiators comprising a combination of a peroxide and a reducing agent such as a combination of a persulfate salt and sodium hydrogensulfite and a combination of a peroxide and sodium ascorbate; and the like can be used, but the polymerization initiator is not limited to these.

One of the polymerization initiators can be used alone, or two or more thereof can be used in combination. The amount of the polymerization initiator is preferably 0.005 to 1 part by weight, and more preferably 0.02 to 0.5 parts by weight based on 100 parts by weight of the total monomers.

Examples of the chain transfer agent include lauryl mercaptan, glycidyl mercaptan, mercaptoacetate, 2-mercaptoethanol, thioglycolic acid, thioglycolic acid 2-ethylhexyl, and 2,3-dimercapto-1-propanol.

One of the chain transfer agents can be used alone, or two or more thereof can be used in combination. The amount of the chain transfer agent is usually 0.01 to 0.1 parts by weight based on 100 parts by weight of the total monomers.

Examples of the emulsifier usable in preparation of the acrylic polymer by emulsion polymerization include anionic emulsifiers such as sodium lauryl sulfate, sodium dodecylbenzenesulfonate, and polyoxyethylene alkyl ether ammonium sulfate; and nonionic emulsifiers such as polyoxyethylene alkylether, polyoxyethylene-polyoxypropylene block polymers. One of these emulsifiers can be used alone, or two or more thereof can be used in combination.

Examples of the emulsifier also include reactive emulsifiers to which a radical polymerizable functional group such as a propenyl group and an allylether group is introduced. Examples of the reactive emulsifier specifically include trade names "Aqualon HS-10," "Aqualon HS-20," "Aqualon KH-10," "Aqualon BC-05," "Aqualon BC-10," and "Aqualon BC-20" (all are made by Dai-ichi Kogyo Seiyaku Co., Ltd.), and "ADEKA REASOAP SE10N" (made by Adeka Corporation).

In order to stably perform the emulsion polymerization, the amount of the emulsifier is preferably 0.3 to 5 parts by weight, and more preferably 0.5 to 1 part by weight based on 100 parts by weight of the monomer.

The reactive emulsifier having a hydrophilic group is taken into the polymer after the polymerization. Accordingly, preferred are reactive emulsifiers because such a reactive emulsifier hardly remains after the reaction, and can provide high moisture resistance of the pressure-sensitive adhesive sheet.

Preferably, the thermally conductive pressure-sensitive adhesive sheet is prepared using the crosslinking agent because a higher adhesive force and durability of the pressure-sensitive adhesive sheet can be provided.
Examples of the crosslinking agent include known crosslinking agents such as isocyanate crosslinking agents, epoxy crosslinking agents, melamine crosslinking agents, oxazoline crosslinking agents, carbodiimide crosslinking agents, aziridine crosslinking agents, and metalchelate crosslinking agents. Among these, preferred are isocyanate crosslinking agents.
One of the crosslinking agents may be used alone, or two or more thereof may be mixed and used.

Examples of the isocyanate crosslinking agents include aromatic isocyanates such as tolylene diisocyanate and xylene diisocyanate; alicyclic isocyanates such as isophorone diisocyanate; and aliphatic isocyanates such as hexamethylene diisocyanate.

Specifically, examples of the isocyanate crosslinking agents include lower aliphatic polyisocyanates such as butylene diisocyanate, hexamethylene diisocyanate; alicyclic isocyanates such as cyclopentylene diisocyanate, cyclohexylene diisocyanate, and isophorone diisocyanates; aromatic diisocyanates such as 2,4-tolylene diisocyanate, 4,4'-diphenylmethane diisocyanate, xylylene diisocyanate, and polymethylene polyphenyl isocyanate; isocyanate adducts such as trimethylolpropane/tolylene diisocyanate trimer adducts (trade name "CORONATE L" made by Nippon Polyurethane Industry Co., Ltd.), trimethylolpropane/hexamethylene diisocyanate trimer adduct (trade name "CORONATE HL" made by Nippon Polyurethane Industry Co., Ltd.), and isocyanurate compounds of hexamethylene diisocyanate (trade name "CORONATE HX" made by Nippon Polyurethane Industry Co., Ltd.); polyether polyisocyanate, polyester polyisocyanate, and adducts of these and a variety of polyols; and polyisocyanates polyfunctionalized by an isocyanurate linkage, a biuret linkage, an allophanate linkage, or the like.

The amount of the crosslinking agent is preferably 0.02 to 5 parts by weight, more preferably 0.04 to 4 parts by weight, and still more preferably, 0.05 to 3 parts by weight based on 100 parts by weight of the acrylic polymer. When the amount of the crosslinking agent is not less than 0.02 parts by weight based on 100 parts by weight of the acrylic polymer, it is advantageous in that a sufficient aggregation force and durability of the pressure-sensitive adhesive sheet can be further ensured. When the amount of the crosslinking agent is not more than 5 parts by weight based on 100 parts by weight of the acrylic polymer, it is advantageous in that excessive crosslinking of the acrylic polymer can be suppressed, providing higher pressure-sensitive adhesiveness of the pressure-sensitive adhesive sheet.

In the pressure-sensitive adhesive sheet, the gel fraction is preferably 40 to 90% by weight, more preferably 50 to 85% by weight, and still more preferably 55 to 80% by weight. At a gel fraction of not less than 40% by weight, it is advantageous in that a sufficient aggregation force can be provided and the durability of the pressure-sensitive adhesive sheet can be enhanced. At a gel fraction of not more than 90% by weight, it is advantageous in that the pressure-sensitive adhesiveness of the pressure-sensitive adhesive sheet can be enhanced. The gel fraction can be controlled by controlling the amount of the crosslinking agent to change the crosslinking degrees of the pressure-sensitive adhesive sheet.

The gel fraction of the pressure-sensitive adhesive sheet (% by weight) is a value determined as follows: a sample having a dry weight W1(g) is taken from the pressure-sensitive adhesive sheet, and dipped in ethyl acetate; an insoluble content of the sample is taken out from ethyl acetate; a weight W2(g) after drying is measured, and (W2/W1) x 100 is calculated.

The thermally conductive filler is a particle filler that improves the thermal conductivity of the pressure-sensitive adhesive sheet when the filler is blended as a component of the pressure-sensitive adhesive sheet, compared to the case where no filler is blended.

The material for the thermally conductive filler is not particularly limited, and examples thereof include inorganic nitrides, metal hydroxides, and metal oxides.

Examples of the inorganic nitrides include boron nitride, aluminum nitride, silicon nitride, and gallium nitride. Examples of the metal hydroxides include aluminum hydroxide and magnesium hydroxide. Among these, preferred is aluminum hydroxide as the metal hydroxides because aluminum hydroxide has higher thermal conductivity and high electric insulation.
Examples of the metal oxides include aluminum oxide, titanium oxide, zinc oxide, tin oxide, copper oxide, nickel oxide, and antimony-doped tin oxide.
Examples of other materials for the thermally conductive filler include silicon carbide, silicon dioxide, calcium carbonate, barium titanate, potassium titanate, copper, silver, gold, nickel, aluminum, platinum, and carbons (carbon black, carbon nanotubes, carbon fibers, and diamond).
One of these thermally conductive fillers can be used alone, or two or more thereof can be used in combination.

The shape of the thermally conductive filler is not particularly limited, and examples thereof include a spherical shape, a needle-like shape, and a plate-like shape. Examples thereof also include deformed shapes thereof.

In the case where the shape is spherical, as the size of the thermally conductive filler, the primary average particle size is preferably 0.1 to 1000 $\mu$m, more preferably 1 to 100 $\mu$m, and still more preferably 2 to 20 $\mu$m. At a primary average particle size of not more than 1000 $\mu$m, the ratio of the size of the thermally conductive filler to the thickness of the pressure-sensitive adhesive sheet can be reduced. Accordingly, it is advantageous in that the thickness of the pressure-sensitive adhesive sheet is hardly varied.

In the case where the shape is a needle-like shape or a plate-like shape, as the size of the thermally conductive filler, the largest length (long axial length or diagonal length) is preferably 0.1 to 1000 $\mu$m, more preferably 1 to 100 $\mu$m, and still more preferably 2 to 20 $\mu$m. When the largest length is not more than 1000 $\mu$m, it is advantageous in that the fillers hardly aggregate, and handling is easy.

The aspect ratio of these fillers (expressed by long axial length/short axial length or long axial length/thickness in the case of a needle-like crystal and expressed by diagonal length/thickness or longer side length/thickness in the case of a plate-like crystal) is preferably 1 to 10000, and more preferably 10 to 1000.

As the thermally conductive filler, commercially available ordinary products can be used. For example, as boron nitride, a trade name "HP-40" (made by Mizushima Ferroalloy Co., Ltd.), a trade name "PT620" (made by Momentive Performance Materials Inc.), and the like can be used. As aluminum hydroxide, a trade name "HIGILITE H-32," a trade name "HIGILITE H-42" (made by Showa Denko K.K.), and the like can be used. As aluminum oxide, a trade name "AS-50" (made by Showa Denko K.K.), and the like can be used. As magnesium hydroxide, a trade name "KISUMA 5A" (made by Kyowa Chemical Industry Co., Ltd.), and the like can be used. As antimony-doped tin oxide, a trade names "SN-1005," "SN-100P," "SN-100D (water dispersion products)" (made by Ishihara Sangyo Kaisha, Ltd.), and the like can be used. As titanium oxide, a trade name "TTO Series" (made by Ishihara Sangyo Kaisha, Ltd.), and the like can be used. As zinc oxide, trade names "ZnO-310," "ZnO-350," "ZnO-410" (made by Sumitomo Osaka Cement Co., Ltd.), and the like can be used.

The amount of the thermally conductive filler is preferably 10 to 1000 parts by weight, more preferably 50 to 500 parts by weight, and still more preferably 80 to 200 parts by weight based on 100 parts by weight of the acrylic polymer. When the amount of the thermally conductive filler is not less than 10 parts by weight based on 100 parts by weight of the acrylic polymer, it is advantageous in that the thermal conductivity of the pressure-sensitive adhesive sheet can be higher. When the amount of the thermally conductive filler is not more than 1000 parts by weight, it is advantageous in that the flexibility of pressure-sensitive adhesive sheet can be higher, providing higher pressure-sensitive adhesive force.

The pressure-sensitive adhesive sheet can be prepared using a silane coupling agent in order to provide a higher adhesive force and durability of the pressure-sensitive adhesive sheet and higher affinity of the thermally conductive filler with the acrylic polymer. As the silane coupling agent, known silane coupling agents can be properly used.

Specifically, examples of the silane coupling agent include epoxy group-containing silane coupling agents, amino group-containing silane coupling agents, (meth)acrylic group-containing silane coupling agents, and isocyanate group-containing silane coupling agents.

In order to improve the adhesive force and durability of the pressure-sensitive adhesive sheet, the pressure-sensitive adhesive sheet can contain a tackifying resin.

Examples of the tackifying resin include known ordinary ones. Examples of the tackifying resin specifically include rosin resins, terpene resins, aliphatic petroleum resins, aromatic petroleum resins, copolymerized petroleum resins, alicyclic petroleum resins, xylene resins, and elastomer resins.

The amount of the tackifying resin in the pressure-sensitive adhesive sheet is preferably 10 to 100 parts by weight, more preferably 20 to 80 parts by weight, and still more preferably 30 to 50 parts by weight based on 100 parts by weight of the acrylic polymer.

Although detailed description will be omitted here, further, the pressure-sensitive adhesive sheet can properly contain ordinary additives blended with rubbers, plastics or the like such as a dispersant, an age resistor, an antioxidant, a processing aid, a stabilizer, an antifoaming agent, a flame retardant, a thickener, and a pigment in the range in which the effects of the present invention are not impaired.

Subsequently, a method of producing a sheet product will be described using an example of a method of producing the thermally conductive sheet product.

Specifically, the thermally conductive sheet product can be produced by performing a composition preparing step of preparing a thermally conductive tackifier composition containing an acrylic polymer and a thermally conductive filler as a raw material for a pressure-sensitive adhesive sheet, a coating step of applying the thermally conductive tackifier composition onto a base separator or a protective separator to form a sheet-shaped pressure-sensitive adhesive sheet, a bonding step of bonding the formed pressure-sensitive adhesive sheet and the protective separator or the base separator to each other, and a cutting step of giving a cut A to the pressure-sensitive adhesive sheet and the protective separator, for example.

In the composition preparing step, more specifically, for example, a polymer solution containing the acrylic polymer and an organic solvent, the thermally conductive filler, and the crosslinking agent and the like when necessary are mixed to prepare a liquid thermally conductive tackifier composition (hereinafter, also referred to as a coating solution).

The composition preparing step is a step for mixing the acrylic polymer with the thermally conductive filler and other components when necessary to prepare the coating solution.

In the composition preparing step, for example, first, the thermally conductive filler is placed in a mixer. Next, the acrylic polymer and the other components are dispersed in an organic solvent to prepare a resin solution, and part of the resin solution is poured into the mixer. The solution is stirred, for example, under reduced pressure of 1 to 20 kPa at normal temperature. Thereby, a particle size controlling step for forming an aggregated thermally conductive filler into fine particles can be performed.

In the particle size controlling step, part of the resin solution needed to prepare the thermally conductive tackifier composition is poured and stirred. Thereby, a high viscosity can be given to a mixture of the filler and the resin solution, and sufficient shear stress can be given to a secondary particle of the thermally conductive filler.

Accordingly, the aggregated thermally conductive filler that has received sufficient shear stress is free from aggregation, and can be formed into a fine particle close to a primary particle. For example, the aggregated thermally conductive filler can be formed into a fine particle having a secondary particle size of not less than 3 $\mu$m and not more than 20 $\mu$m.

In the particle size controlling step, more specifically, the mixer is set at a relatively low number of rotation, for example, not more than 30 rpm, and preferably 10 to 20 rpm, and the stirring operation can be continued until the viscosity reaches a degree in which it is no longer found that the filler dispersed in the resin solution adheres to the stirring blade of the mixer.

In the coating step, using a known ordinary coating method, the liquid thermally conductive tackifier composition (coating solution) thus prepared can be applied to the protective separator, for example. After the application, the organic solvent is volatilized from the coating solution. Thereby, a sheet-shaped pressure-sensitive adhesive sheet can be formed.

As the coating method, methods such as roll coating, kiss roll coating, gravure coating, reverse coating, roll blush coating, spray coating, dip roll coating, bar coating, knife coating, air knife coating, curtain coating, lip coating, and extrusion coating by a die coater or the like can be used, for example.

In the bonding step, for example, a pressure-sensitive adhesive sheet formed on a protective separator can be bonded to the base separator.

In the cutting step, for example, the process to give a cut to the pressure-sensitive adhesive sheet and the protective separator (hereinafter, also referred to as the half cut process) can be performed. The method for the half cut process is not particularly limited, and a known ordinary method can be used. Specifically, examples thereof include a method by punching in which using a Thompson blade or the like, a press machine makes the cutting blade cut only the protective separator and the pressure-sensitive adhesive sheet to form the cut A. The method by punching using the Thompson blade is preferred because the base sheet is hardly cut off.

The sheet product according to the embodiment is as exemplified above, but the present invention will not be limited to the sheet product exemplified above. A variety of forms used in ordinary sheet products can be used in the present invention in the range in which the effects of the present invention are not impaired.

In the embodiment, the sheet product has been described in which in the pressure-sensitive adhesive sheet and the protective separator having the cut, the edge sides of the pressure-sensitive adhesive sheet piece and the protective separator piece of a separate piece to be divided abut the edge sides of those of an adjacent separator piece, but the present invention will not be limited to such an embodiment. For example, the present invention may be a sheet product in which the edge sides of the pressure-sensitive adhesive sheet piece and the protective separator piece of a separate piece are spaced from the edge sides of those of an adjacent separate piece.

Moreover, as shown in Fig. 3, for example, the pressure-sensitive adhesive sheet in the sheet product may include a first pressure-sensitive adhesive sheet 1x (on the side of the protective separator) and a second pressure-sensitive adhesive sheet 1y (on the side of the base separator), one surface of the first pressure-sensitive adhesive sheet 1x being disposed facing one surface of the second pressure-sensitive adhesive sheet 1y; and an intermediate layer 1m disposed between the first pressure-sensitive adhesive sheet 1x and the second pressure-sensitive adhesive sheet 1y and mechanically supporting the sheet product.

Similarly to the sheet product according to the embodiment, in use of the sheet product having such a pressure-sensitive adhesive sheet, usually, the separate piece on the side of the second pressure-sensitive adhesive sheet is applied to the heat generating body, such as an electronic device, the protective separator piece is removed from the separate piece, and a heat sink (not shown) or the like is attached to the exposed surface of the first pressure-sensitive adhesive sheet. Thereby, the heat generating body, such as the electronic device, can be fixed to the heat sink or the like. Moreover, it is advantageous in that the intermediate layer in the pressure-sensitive adhesive sheet suppresses undesirable folding of the sheet product and the like, providing higher handling properties.

Examples

Next, using Examples, the present invention will be described more in detail, but the present invention will not be limited to these.

Production examples of the sheet products including thermally conductive pressure-sensitive adhesive sheet as the pressure-sensitive adhesive sheet, and results of various evaluations of the produced sheet products will be described below.

(Example 1)

"Preparation of acrylic polymer"

The blending components shown below were placed in a reaction container having a cooling pipe, a nitrogen introducing pipe, a thermometer, and a stirrer, and purging of the system with nitrogen gas was sufficiently performed.

butyl acrylate: 70 parts by weight
2-ethylhexyl acrylate: 30 parts by weight
acrylic acid: 3 parts by weight
2,2'-azobisisobutyronitrile (polymerization initiator): 0.1 parts by weight toluene (polymerization solvent): 155 parts by weight

These were heated at 80°C for 3 hours to prepare an acrylic polymer solution having a solid content of 40.0% by weight.

"Preparation of thermally conductive tackifier composition"

The blending components shown below were added to 100 parts by weight of the solid content in the acrylic polymer solution to prepare a heat conductive tackifier composition.

aluminum hydroxide (thermally conductive filler)
(made by Showa Denko K.K., a trade name "HIGILITE H-32"): 100 parts by weight,
polyisocyanate compound (isocyanate crosslinking agent)
(made by Nippon Polyurethane Industry Co., Ltd., a trade name "CORONATE L"): 3 parts by weight

"Base separator"

PET separator (PET film having a thickness of 100 $\mu$m and subjected to a releasing treatment, made by Mitsubishi Polyester Film Corporation, a trade name "PET SEPA MRV," surface roughness Ra on the release treated surface = 0.04 $\mu$m)

"Production of protective separator"

A protective separator was produced by applying the thermosetting silicone shown below onto the PET film shown below and drying the thermosetting silicone. A setting catalyst for setting the thermosetting silicone was used.

PET film (made by Toray Industries, Inc., "Lumirror S10#75")
thermosetting silicone (made by Shin-Etsu Chemical Co., Ltd., product No. "KS-774," addition reaction type)
setting catalyst (made by Shin-Etsu Chemical Co., Ltd., "PL-3")

The thermosetting silicone was diluted with toluene, and the solid content was adjusted to 0.5%. Using the diluted thermosetting silicone, coating was performed under the following conditions to produce a protective separator (thickness of 75 $\mu$m). The surface roughness Ra of the protective separator on the coated side was 0.04 $\mu$m.

blending condition: "KS-774":"PL-3" = 100:0.6 (parts by weight)
drying conditions: 150°C, 1 minute

The thermally conductive tackifier composition was applied to the surface coated with the thermosetting silicone in the produced protective separator such that the thickness of the thermally conductive tackifier composition after drying was 50 $\mu$m, and dried at 70°C for 15 minutes to form a thermally conductive pressure-sensitive adhesive sheet on the protective separator.
The release treated surface of the base separator was bonded to the thermally conductive pressure-sensitive adhesive sheet. Using a method described later, a cut was given to the thermally conductive pressure-sensitive adhesive sheet and the protective separator to produce a sheet product.

**EP 2 578 652 A1**

(Example 2)

Using a polyester film (Toray Lumirror S10#12) having a thickness of 12 $\mu$m and serving as an intermediate layer in the thermally conductive pressure-sensitive adhesive sheet, the thermally conductive tackifier composition was applied to both surfaces of the polyester film by the same coating method as that in Example 1 to form a thermally conductive pressure-sensitive adhesive sheet having a thickness of 50 $\mu$m. Subsequently, in the same manner as in Example 1, the protective separator was bonded to one of the surfaces of the thermally conductive pressure-sensitive adhesive sheet, the base separator was bonded to the other of the surfaces of the thermally conductive pressure-sensitive adhesive sheet, and a cut was given to the pressure-sensitive adhesive sheet and the protective separator by the method described later. Thereby, a sheet product as shown in Fig. 3 was produced.

(Example 3)

A sheet product was produced in the same manner as in Example 1 except that a PET separator having a thickness of 75 $\mu$m (made by Mitsubishi Polyester Film Corporation, a trade name "PET SEPA MRF," release treated PET film, surface roughness Ra on the release treated surface = 0.04 $\mu$m) was used as the base separator.

(Example 4)

"Production of base separator"

A base separator was produced by applying the thermosetting silicone shown below onto the laminate paper shown below and drying the thermosetting silicone. A setting catalyst for setting the thermosetting silicone was used.

polyethylene laminate paper (backing: high quality paper having a basis weight of 80 g/m$^2$)
thermosetting silicone (made by Shin-Etsu Chemical Co., Ltd., product No. "KS-774," addition reaction type)
setting catalyst (made by Shin-Etsu Chemical Co., Ltd., "PL-3")

The thermosetting silicone was diluted with toluene, and the solid content was adjusted to 0.6%. Using the diluted thermosetting silicone, coating was performed under the following conditions to produce a base separator (thickness of 130 $\mu$m). The surface roughness Ra of the base separator on the coated side was 0.4 $\mu$m.

blending condition: "KS-774":"PL-3" = 100:0.6 (parts by weight)
drying conditions: 120°C, 2 minutes

"Production of protective separator"

A protective separator was produced by applying the thermosetting silicone shown below onto the laminate paper shown below and drying the thermosetting silicone. A setting catalyst for setting the thermosetting silicone was used.

polyethylene laminate paper (backing: high quality paper having a basis weight of 80 g/m$^2$)
thermosetting silicone (made by Shin-Etsu Chemical Co., Ltd., product No. "KS-774," addition reaction type)
setting catalyst (made by Shin-Etsu Chemical Co., Ltd., "PL-3")

The thermosetting silicone was diluted with toluene, and the solid content was adjusted to 0.5%. Using the diluted thermosetting silicone, coating was performed under the following conditions to produce a protective separator (thickness of 130 $\mu$m). The surface roughness Ra of the protective separator on the coated side was 0.4 $\mu$m.

blending condition: "KS-774":"PL-3" = 100:0.6 (parts by weight)
drying conditions: 120°C, 2 minutes

The same thermally conductive pressure-sensitive adhesive sheet as that in Example 1 was formed on the produced protective separator, and the base separator was bonded to the thermally conductive pressure-sensitive adhesive sheet. A sheet product was produced by the same method as that in Example 1.

(Comparative Example 1)

A sheet product was produced in the same manner as in Example 1 except that a PET separator having a

thickness of 50 μm (made by Mitsubishi Polyester Film Corporation, a trade name "PET SEPA MRF," release treated PET film, surface roughness Ra on the release treated surface = 0.04 μm) was used as the base separator, and a PET film having a thickness of 38 μm (Toray Lumirror S10#38) was used as the backing for the protective separator to produce a protective separator having a surface roughness Ra = 0.04 μm.

(Comparative Example 2)

A sheet product was produced in the same manner as in Example 1 except that a base separator produced by applying the thermosetting silicone shown below onto the PET film shown below and drying the thermosetting silicone was used.

PET film (made by Toray Industries, Inc. "Lumirror S10#75")
thermosetting silicone (made by Shin-Etsu Chemical Co., Ltd., product No. "KS-774," addition reaction type)
setting catalyst (made by Shin-Etsu Chemical Co., Ltd., "PL-3")

The thermosetting silicone was diluted with toluene, and the solid content was adjusted to 2.0%. Using the diluted thermosetting silicone, coating was performed under the following conditions to produce a base separator (thickness of 100 μm). The surface roughness Ra of the base separator on the coated side was 0.04 μm.

blending condition: "KS-774":"PL-3" = 100:0.6 (parts by weight)
drying conditions: 150°C, 1 minute

(Comparative Example 3)

A sheet product was produced in the same manner as in Example 1 except that a thermosetting silicone having a solid content of 2.0% by weight was used in the production of the protective separator. The surface roughness Ra of the protective separator on the coated side was 0.04 μm, and the thickness of the protective separator was 75 μm.

(Comparative Example 4)

"Production of base separator"

A base separator produced by applying the thermosetting silicone shown below onto the PET film shown below and drying the thermosetting silicone was used.

PET film (made by Toray Industries, Inc., "Lumirror S10#100")
thermosetting silicone (made by Shin-Etsu Chemical Co., Ltd., product No. "KS-774," addition reaction type)
setting catalyst (made by Shin-Etsu Chemical Co., Ltd., "PL-3")

The thermosetting silicone was diluted with toluene, and the solid content was adjusted to 0.5%. Using the diluted thermosetting silicone, coating was performed under the following conditions to produce a base separator (thickness of 100 μm). The surface roughness Ra of the base separator on the coated side was 0.04 μm.

blending condition: "KS-774":"PL-3" = 100:0.6 (parts by weight)
drying conditions: 150°C, 1 minute

"Production of protective separator"

Meanwhile, a PET separator having a thickness of 75 μm (made by Mitsubishi Polyester Film Corporation, a trade name "PET SEPA MRF," release treated PET film, surface roughness Ra on the coated side of the release treated surface = 0.04 μm) was used as the protective separator.
A sheet product was produced in the same manner as in Example 1 except that the base separator and the protective separator described above were used.

(Comparative Example 5)

"Production of base separator"

A base separator was produced by applying the thermosetting silicone shown below onto the laminate paper shown below and drying the thermosetting silicone. A setting catalyst for setting the thermosetting silicone was used.

polyethylene laminate paper (thickness of 130 $\mu$m, backing: high quality paper having a basis weight of 80 g/m$^2$)
thermosetting silicone (made by Shin-Etsu Chemical Co., Ltd., product No. "KS-774," addition reaction type)
setting catalyst (made by Shin-Etsu Chemical Co., Ltd., "PL-3")

The thermosetting silicone was diluted with toluene, and the solid content was adjusted to 0.8%. Using the diluted thermosetting silicone, coating was performed under the following conditions, and the coated surface was embossed to produce a base separator. The surface roughness Ra of the base separator on the coated side was 4 $\mu$m.

blending condition: "KS-774":"PL-3" = 100:0.6 (parts by weight)
drying conditions: 120°C, 2 minutes

"Production of protective separator"

A protective separator was produced by applying the thermosetting silicone shown below onto the laminate paper shown below and drying the thermosetting silicone. A setting catalyst for setting the thermosetting silicone was used.

polyethylene laminate paper (thickness of 130 $\mu$m, backing: high quality paper having a basis weight of 80 g/m$^2$)
thermosetting silicone (made by Shin-Etsu Chemical Co., Ltd., product No. "KS-774," addition reaction type)
setting catalyst (made by Shin-Etsu Chemical Co., Ltd., "PL-3")

The thermosetting silicone was diluted with toluene, and the solid content was adjusted to 0.7%. Using the diluted thermosetting silicone, coating was performed under the following conditions, and the coated surface was embossed to produce a protective separator. The surface roughness Ra of the protective separator on the coated side was 4 $\mu$m.

blending condition: "KS-774":"PL-3" = 100:0.6 (parts by weight)
drying conditions: 120°C, 2 minutes

A thermally conductive pressure-sensitive adhesive sheet was formed on the produced protective separator in the same manner as in Example 1, and the base separator was bonded to the thermally conductive pressure-sensitive adhesive sheet. Thus, a sheet product was produced in the same manner as in Example 1.

<Evaluation of cut>

In production of the sheet products according to Examples and Comparative Examples, the state was visually observed after punching was performed in order to give a cut to the pressure-sensitive adhesive sheet and the protective separator. Evaluation was made using 100 samples, and determined based on the following items. The punching was performed by a press machine including a Thompson blade, and a cut was given to the pressure-sensitive adhesive sheet and the protective separator to form the pressure-sensitive adhesive sheet and the protective separator into square sheet-shaped separate pieces of 2 cm x 2 cm. The number of air bubbles mixed was evaluated when there was no penetration by the punching blade.

"Evaluation items"

penetration by the punching blade: present or absent
the number of air bubbles mixed: the number of samples per 100 samples in which the air bubbles are mixed

(the sample is considered acceptable when the sample has no penetration by the punching blade, and the number of the air bubbles mixed is not more than 20)

<Measurement of peel force>

The sheet products produced in Examples and Comparative Examples were cut into a size of a width of 50 mm and a length of 100 mm to produce a sample for measuring a peel force. Specifically, using a tensile tester (made by Minebea Co., Ltd., a mutifunctional tensile tester "TCM-1kNB"), under the temperature condition of 23°C, the thermally conductive pressure-sensitive adhesive sheet was placed downwardly, and the separator was peeled from the thermally conductive pressure-sensitive adhesive sheet at an angel of 180° at a tensile rate of 300 mm/min. The force needed when peeling was determined as the peel force.

<Evaluation of workability in use>

In each of the sheet products produced in Examples and Comparative Examples, 100 samples were actually peeled, and the number of occurrences of "naki-wakare" or peeling of only the protective separator (the number of unintended peeling) was counted, and the workability in use was evaluated. When the sample was not considered acceptable in the "Evaluation of cut," the sample was not subjected to the present evaluation.

"Evaluation items"

the number of unintended peeling: the number of samples showing unintended peeling per 100 samples

(the sample is considered acceptable when the number of unintended peeling is not more than 20)

<Measurement of thermal resistance>

Each of the sheet products produced in Examples and Comparative Examples was cut into a size of a width of 20 mm x a length of 20 mm, the base separator and the protective separator were removed, and a sample of the thermally conductive pressure-sensitive adhesive sheet for measurement was produced. The thermal resistance was measured using a "TC-200" made by ESPEC Corp. As the measurement conditions, a load was 100 N, and the temperature of the heat generating body was 80°C.

Results of evaluation of the sheet products according to Examples and Comparative Examples are shown in Table 1.

[Table 1]

| | Unit | Example 1 | Example 2 | Example 3 | Example 4 | Comparative Example 1 | Comparative Example 2 | Comparative Example 3 | Comparative Example 4 | Comparative Example 5 |
|---|---|---|---|---|---|---|---|---|---|---|
| Thickness of base separator | μm | 100 | 100 | 75 | 130 | 50 | 100 | 100 | 100 | 130 |
| Thickness of protective separator | μm | 75 | 75 | 75 | 130 | 38 | 75 | 75 | 75 | 130 |
| Peel force (base separator side) | N/50 mm | 0.25 | 0.25 | 0.25 | 0.25 | 0.25 | 0.02 | 0.25 | 0.29 | 0.25 |
| Peel force (protective separator side) | N/50 mm | 0.29 | 0.29 | 0.29 | 0.29 | 0.29 | 0.29 | 0.05 | 0.25 | 0.29 |
| Surface roughness Ra (base separator) | μm | 0.04 | 0.04 | 0.04 | 0.4 | 0.04 | 0.04 | 0.04 | 0.04 | 4 |
| Surface roughness Ra (protective separator) | μm | 0.04 | 0.04 | 0.04 | 0.4 | 0.04 | 0.04 | 0.04 | 0.04 | 4 |
| After giving cut — Penetration by punching blade | | Absent | Absent | Absent | Absent | Present | Absent | Absent | Absent | Absent |
| After giving cut — The number of air bubbles mixed | | 2/100 | 2/100 | 15/100 | 17/100 | - | 42/100 | 3/100 | 3/100 | 90/100 |
| Evaluation of workability — The number of unintended peeling | | 2/100 | 2/100 | 5/100 | 7/100 | - | - | 38/100 | 52/100 | - |
| Thermal resistance | cm² · K/W | 1.45 | 3.4 | 1.45 | 1.45 | 1.45 | 1.45 | 1.45 | 1.45 | 2.8 |

Apparently from the results in Table 1, Example 1 can provide good results. Meanwhile, in Comparative Example 1, penetration by the punching blade was found. It was found that the air bubbles are likely to be mixed in punching in Comparative Example 2, and Comparative Examples 3 and 4 have poor workability. In Comparative Example 5, the air bubbles are very likely to be mixed in punching.

REFERENCE SIGNS LIST

1:    pressure-sensitive adhesive sheet
2:    base separator
3:    protective separator
4:    heat generating body
5:    sheet product
A:    cut

**Claims**

1. A sheet product comprising a sheet-shaped pressure-sensitive adhesive sheet having pressure-sensitive adhesiveness; a base separator disposed on one surface side of the pressure-sensitive adhesive sheet so as to be peelable from the pressure-sensitive adhesive sheet, and supporting the pressure-sensitive adhesive sheet and serving as a base; and a protective separator disposed on the other surface side of the pressure-sensitive adhesive sheet so as to be peelable from the pressure-sensitive adhesive sheet, wherein
a peel force between the pressure-sensitive adhesive sheet and the base separator is smaller than a peel force between the pressure-sensitive adhesive sheet and the protective separator and is 0.05 to 0.8 N/50 mm; a cut is given to the pressure-sensitive adhesive sheet and the protective separator in a direction of a thickness of the pressure-sensitive adhesive sheet such that the pressure-sensitive adhesive sheet and the protective separator can be peeled from the base separator as a separate piece in the state where the pressure-sensitive adhesive sheet and the protective separator are layered; a thickness of the base separator is not less than 60 $\mu$m; and in the base separator and the protective separator, a respective surface roughness Ra on the side of the pressure-sensitive adhesive sheet is not more than 3 $\mu$m.

2. The sheet product according to claim 1, wherein the pressure-sensitive adhesive sheet comprises an acrylic polymer and a thermally conductive filler.

3. The sheet product according to claim 1 or 2, wherein the cut is given in a lattice form such that the separate piece of the pressure-sensitive adhesive sheet and the protective separator layered can be peeled from the base separator as a small sheet-shaped rectangular piece.

4. The sheet product according to any one of claims 1 to 3, wherein the peel force between the pressure-sensitive adhesive sheet and the protective separator is more than 0.05 N/50 mm.

5. The sheet product according to any one of claims 1 to 4, wherein the thickness of the protective separator is less than the thickness of the base separator.

6. The sheet product according to claim 5, wherein the thickness of the protective separator is not less than 20 $\mu$m.

7. The sheet product according to any one of claims 1 to 6, wherein the base separator and the protective separator are formed from a backing of the same kind.

# Fig. 1(a)

5

A

3

2

# Fig. 1(b)

5

A        A

3

1

2

# Fig. 2(a)

3 a

1 a

3

1

2

# Fig. 2(b)

3 a

1 a

4

# Fig. 3

5

A    A

3

1 m

1 x

1 y

2

## INTERNATIONAL SEARCH REPORT

| | International application No. |
|---|---|
| | PCT/JP2011/062201 |

A. CLASSIFICATION OF SUBJECT MATTER
*C09J7/02*(2006.01)i, *C09J11/04*(2006.01)i, *C09J133/00*(2006.01)i, *H01L21/36*
(2006.01)i

According to International Patent Classification (IPC) or to both national classification and IPC

B. FIELDS SEARCHED

Minimum documentation searched (classification system followed by classification symbols)
C09J1/00-201/10, H01L21/34-21/36

Documentation searched other than minimum documentation to the extent that such documents are included in the fields searched
Jitsuyo Shinan Koho          1922-1996     Jitsuyo Shinan Toroku Koho     1996-2011
Kokai Jitsuyo Shinan Koho    1971-2011     Toroku Jitsuyo Shinan Koho     1994-2011

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2010-21407 A (Polymatech Co., Ltd.), 28 January 2010 (28.01.2010), claims; paragraphs [0018] to [0020], [0025], [0029], [0034], [0035], [0038], [0039]; fig. 4 & US 2010/0009109 A1     & CN 101625210 A | 1-7 |
| Y | JP 2009-45789 A (Polymatech Co., Ltd.), 05 March 2009 (05.03.2009), claims; paragraph [0033]; fig. 2 to 4 (Family: none) | 1-7 |
| Y | JP 56-94381 A (Toyonori TAMADA), 30 July 1981 (30.07.1981), claims; page 2, upper right column, lines 4 to 19; fig. 1, 2 (Family: none) | 1-7 |

☒ Further documents are listed in the continuation of Box C.          ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 17 August, 2011 (17.08.11) | 30 August, 2011 (30.08.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
|---|
| PCT/JP2011/062201 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2005-350650 A  (Nitto Denko Corp.), 22 December 2005 (22.12.2005), claims; paragraph [0036] & US 2005/0266195 A1    & EP 1595927 A1 & KR 10-2006-0047765 A   & SG 117577 A & CN 1704237 A | 1-7 |
| Y | CD-ROM of the specification and drawings annexed to the request of Japanese Utility Model Application No. 17198/1994(Laid-open No. 1220/1996) (Nitto Denko Corp.), 30 July 1996 (30.07.1996), claims; page 4, lines 3 to 18 (Family: none) | 1-7 |
| Y | JP 2005-154689 A  (Hitachi Chemical Co., Ltd.), 16 June 2005 (16.06.2005), claims; paragraph [0018] (Family: none) | 1-7 |
| A | JP 2007-59464 A  (Denki Kagaku Kogyo Kabushiki Kaisha), 08 March 2007 (08.03.2007), claims; paragraphs [0014], [0015], [0033] to [0037] (Family: none) | 1-7 |

Form PCT/ISA/210 (continuation of second sheet) (July 2009)

**EP 2 578 652 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007059464 A
- JP 2002084083 A

- JP 2005015933 A

**Non-patent literature cited in the description**

- Handbook of Pressure Sensitive Adhesive Technology. Nikkan Kogyo Shimbun, Ltd,